# EUROPÄISCHE PATENTANMELDUNG

(11) **EP 1 655 783 A1**
(43) Veröffentlichungstag der Anmeldung: **10.05.2006**
(21) Anmeldenummer: 05023837.7
(22) Anmeldetag: 02.11.2005
(51) Int. Cl.: H01L 29/737, H01L 29/10, H01L 21/331

(54) **Verfahren zur Herstellung eines Halbleiterbauelements**

(30) Priorität: 05.11.2004 DE 102004053393
(71) Anmelder: ATMEL Germany GmbH, 74072 Heilbronn (DE)
(72) Erfinder: Bromberger, Christoph, Dipl.-Phys., 74074 Heilbronn (DE)

(57) **Zusammenfassung**

Verfahren zur Herstellung eines Halbleitergegenstandes, insbesondere eines Hochfrequenz-Bipolartransistors oder einer vertikal integrierten Hochfrequenz-Kaskodenstruktur,
wobei
- ein Basisbereich aus einem ersten Halbleitermaterial aufgebracht wird,
- oberhalb des Basisbereichs eine Silizidschicht aufgebracht wird,
- nach dem Aufbringen der Silizidschicht in der Silizidschicht eine Öffnung erzeugt wird, indem die Silizidschicht im Bereich der Öffnung entfernt wird, und
- nachfolgend innerhalb der Öffnung ein Emitterbereich ausgebildet wird.

## Beschreibung

Die vorliegende Erfindung betrifft ein Verfahren zur Herstellung eines Halbleitergegenstandes und einen Halbleitergegenstand, insbesondere für Hochfrequenzanwendungen.

In der DE 43 01 333 A1 werden verschiedene Prozessschritte beim Herstellungsverfahren eines NPN-Silizium-Germanium-Heterobipolartransistors mit einer P-Silizium-Germanium Basisschicht offenbart. Auf diese Schrift wird vollumfänglich Bezug genommen und die Prozessschritte in den Figuren 1 a bis 1i erläutert.

Fig. 1a: Auf der Oberfläche einer P-dotierten Silizium-Substratscheibe 1 s wird durch thermische Oxidation eine (Maskier-) Oxidschicht 10s gebildet und unter Verwendung von Fotolack strukturiert; eine N⁺-Kollektoranschlussschicht 2s ("burried layer") wird durch Implantation und Nachdiffusion von Arsen-Ionen gebildet.

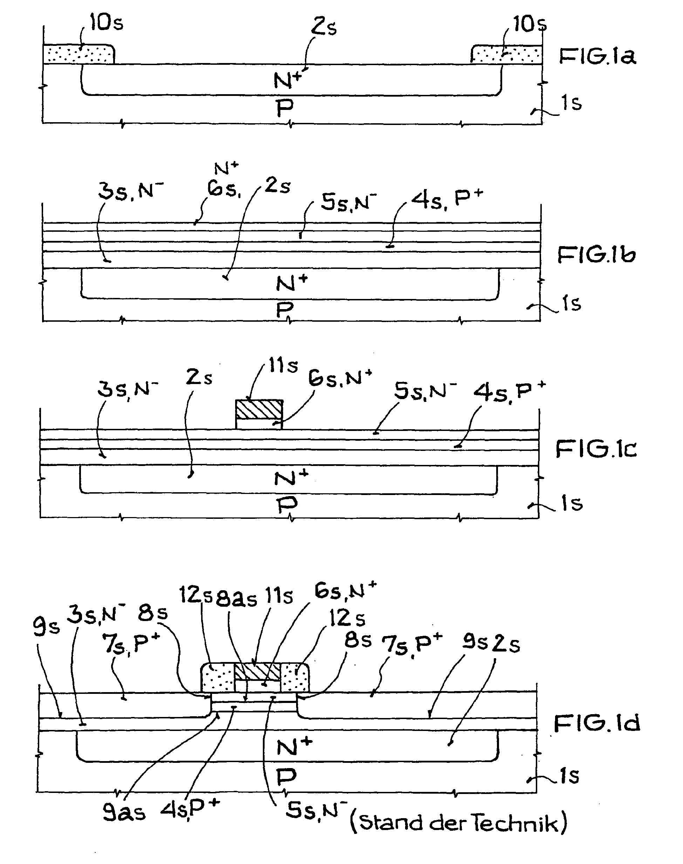

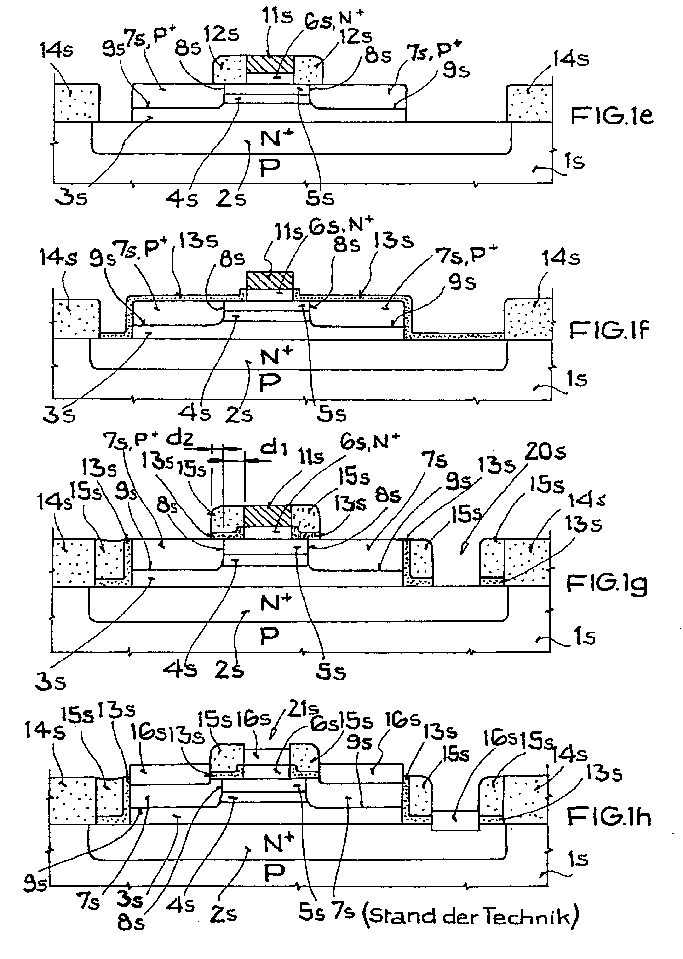

Fig. 1 b: Nach Entfernen der Maskier-Oxidschicht 10s wird die Schichtenfolge des SiGe-HBTs in einem einzigen Prozess (beispielsweise mittels Molekularstrahlepitaxie MBE) ohne Unterbrechung bei gleichzeitiger Dotierung der Schichten gewachsen. Die Schichtenfolge umfasst die N-Kollektorschicht 3s (bspw. mit einer Schichtdicke 300 nm und einer Dotierungskonzentration von 10¹⁶ bis 10¹⁷ cm⁻³), die P⁺-SiGe-Basisschicht 4s (Germaniumanteil beispielsweise 20%, Schichtdicke 50 nm und Dotierungskonzentration 10¹⁹ cm⁻³), die N⁻-Emitterschicht 5s (bspw. mit einer Schichtdicke von 100 nm und einer Dotierungskonzentration von 10¹⁸ cm⁻³) sowie die N⁺-Emitteranschlussschicht 6s bspw. Schichtdicke 50 nm und Dotierungskonzentration größer 10²⁰ cm⁻³).

Fig. 1c: Auf die N⁺-Emitteranschlussschicht 6s wird ganzflächig (beispielsweise durch CVD-Verfahren) eine Hilfsschicht 11 s (beispielsweise aus Siliziumnitrid Si₃N₄) mit einer Schichtdicke von ca. 0,3 µm abgeschieden und mittels Fotolack strukturiert; ein Teilbereich der Si₃N₄-Hilfsschicht 11s und der Si-Emitteranschlussschicht 6s wird anisotrop abgeätzt - die Emitterschicht 5s verbleibt weiterhin über der SiGe-Basisschicht 4s.

Fig. 1d: Auf die Oberfläche der Halbleiteranordnung wird eine CVD-Oxid (TEOS) 12s (beispielsweise mit einer Schichtdicke von 0,3 µm) konform abgeschieden und derart anisotrop rückgeätzt, dass nur an den senkrechten Kanten der Hilfsschicht 11s und der Emitteranschlussschicht 6s eine Oxidschicht 12s (Spacer) verbleibt und die restliche Oberfläche (für den Basisanschluss) freigelegt wird; in die freiliegende Oberfläche werden BF2-Ionen (Dosis beispielsweise 4 x 10¹⁵ cm⁻², Beschleunigungsspannung beispielsweise 40 - 80 kV) bis in eine Tiefe knapp unterhalb der SiGe-Basisschicht 4s implantiert und dadurch das seitlich der Oxidspacer 12s liegende Emittergebiet 5s zum P⁺-Basisanschlussgebiet 7s umdotiert sowie der Basis-Kollektor-PN-Übergang 9s unter die Basis-Kollektor-Grenzschicht 9as und der Emitter-Basis-PN-Übergang 8s unter die Spacer-Oxidschicht 12s verschoben.

Fig. 1e: Die endgültige Mesastruktur wird herausgebildet, indem Basisanschlussgebiet 7s und Kollektorschicht 3s durch anisotropes Ätzen strukturiert werden; durch Abscheidung und Strukturierung eines CVD-Oxids (Schichtdicke beispielsweise 0,5 µm) werden Feldoxidgebiete 14s gebildet, die die einzelnen Bauelemente bzw. aktiven Strukturen der integrierten Schaltung voneinander separieren.

Fig. 1f: Durch thermische Oxidation bei einer Temperatur von beispielsweise 700°C wird die freiliegende Oberfläche der Halbleiteranordnung mit einer beispielsweise 10 nm dicken SiO₂-Schicht 13s überzogen. Sowohl der Basis-Emitter-PN-Übergang 8s als auch der Kollektor-Basis-PN-Übergang 9s werden an der Oberfläche passiviert und somit vor Leckströmen geschützt.

Fig. 1g: Auf die Oberfläche der Halbleiteranordnung wird ganzflächig ein CVD-Oxid 15s (TEOS) abgeschieden (bspw. mit einer Schichtdicke von 0,5 µm) und derart anisotrop rückgeätzt, dass zum einen die Kollektor-Kontaktöffnung 20s gebildet wird und zum anderen Oxidspacer 15s verbleiben, die die Oberfläche des Basis-Emitter-PN-Übergangs 8s über eine Länge d₂ schützen. Die Abstände d₁ (vom Rand der Emitteranschlussschicht 6s bis zum Basisanschlussgebiet 7s) und d₂ (vom Basisanschlussgebiet 7s bis zum späteren Basis-Metall 16s) werden durch die beschriebene Spacertechnik unter Verwendung der Oxidschichten 12s und 15s selbstjustiert und minimal.

Fig. 1h: Der restliche Teil der Si₃N₄-Hilfsschicht 11 s wird entfernt und die Emitter-Kontaktöffnung 21 s freigelegt. Durch Aufdampfen einer Metallschicht 16s (beispielsweise Titan) und deren Temperaturbehandlung wird auf der Oberfläche der Silizium-Bereiche 2s, 6s, 7s ein Metall-Silizid (Bsp. Titan-Silizid) gebildet, während auf der Oberfläche der Oxidbereiche 13s, 14s, 15s das reine Metall verbleibt; die Metallschicht über den Oxidbereichen 13s, 14s, 15s wird mittels einer Ätzlösung selektiv entfernt. Anschließend kann nach Aufbringen einer Oxidschicht und Herstellung von Kontaktöffnungen für Emitter, Basis und Kollektor eine Metallisierung mittels üblicher Verfahren aufgebracht werden. Derartige SiGe-HBTs der Fig. 1 h können jedoch nicht nur, wie dargestellt, auf einfach strukturierten Substraten gefertigt werden, sondern beispielsweise auch auf Substraten, die bereits fertige Bauelemente in reiner Silizium-Technologie (bspw. MOS oder Bipolar) enthalten.

Die Basis des zuvor beschriebenen Transistors lässt sich gedanklich in eine innere Basis und eine äußere Basis gliedern. Die innere Basis bildet mit angrenzenden Emitter- und Kollektorgebieten ebene und im Wesentlichen parallele pn-Übergänge aus, während die äußere Basis zur elektrischen Verbindung der inneren Basis mit zumindest einem äußeren Kontakt ausgebildet ist.

Für viele Anwendungen von Bipolartransistoren, so beispielsweise für die Hochfrequenz-Leistungsverstärkung, ist der Basiswiderstand ein wichtiger Parameter, der die elektrischen Eigenschaften der Transistoren, insbesondere deren Grenzfrequenz begrenzt. Häufig wird der Basiswiderstand vom Widerstand der äußeren Basis dominiert.

Um den Widerstand der äußeren Basis zu reduzieren, ist die äußere Basis in hochdotiertem Halbleitermaterial vom selben Dotierstofftyp wie dem der inneren Basis ausgeführt, jedoch mit einer erheblich höheren Schichtdicke, um so einen niedrigen Schichtwiderstand zu erzielen. Bei dem in der Druckschrift "IEEE-IEDM 2002, Artikel 31.6.1" gelehrten Verfahren wird beispielsweise die äußere Basis in Polysilizium einer Schichtdicke ausgeführt, die erheblich über der Weite der inneren Basis liegt. Zudem kann die äußere Basis als hochdotierter implantierter Bereich ausgeführt sein.

Um den Widerstand der äußeren Basis von Bipolartransistoren der Siliziumtechnologie zu reduzieren, wird die äußere Basis silizidiert, wie dies bspw. in den Druckschriften US 5,459,084, US 6,177,717, US 2002/0168829 oder US 6,465,317 ausgeführt ist. Hierbei wird auf die äußere Basis eine Schicht aus einem mit Silizium reaktionsfähigen Metall aufgebracht und dieses mit dem Siliziummaterial der äußeren Basis zur Reaktion gebracht. Durch ein Tempern oberhalb einer Umwandlungstemperatur werden die entstehenden Silizide in eine Modifikation mit einem geringen spezifischen Widerstand überführt.

Für viele Anwendungen, insbesondere im Hochfrequenzbereich, ist es wünschenswert, neben Silizium ein weiteres Halbleitermaterial, beispielsweise Germanium oder Kohlenstoff, in die innere Basis eines Bipolartransistors einzubringen, um einen Heterobipolartransistor herzustellen. Bei der epitaktischen Abscheidung des Halbleitermaterials für die innere Basis wird auch in Teile der äußeren Basis neben Silizium das weitere Halbleitermaterial eingebracht. Germanium und Kohlenstoff verhalten sich chemisch ähnlich wie Silizium, so dass ein mit Silizium reaktionsfähiges Metall unter den selben Reaktionsbedingungen auch mit Germanium oder Kohlenstoff reagiert.

Insbesondere Verbindungen zwischen Titan und Germanium weisen eine geringere thermische Stabilität auf als homologe Verbindungen zwischen Titan und Silizium und dissoziieren bei der Umwandlungstemperatur der Silizide. Die bei der Dissoziierung gebildeten Germanium- und Titan-Ausscheidungen wirken widerstandserhöhend.

Bei Vorhandensein eines weiteren Halbleitermaterials (Germanium) in der inneren Basis kann es daher wünschenswert sein, die Silizidierungsreaktion so zu führen, dass die Silizidierungsfront nicht bis in die Tiefe der inneren Basis vordringt. Dennoch ist zur Verringerung des Basiswiderstandes eine hohe Siliziddicke wünschenswert.

Hierzu ist, wie zuvor in der DE 43 01 333 A1 beschrieben, eine dicke Emitterschicht 5s vorgesehen, die dazu dient, Siliziummaterial für eine dicke Silizidschicht 16s vorzuhalten, ohne dass die Silizidierungsfront bis in die Tiefe der Schicht 4s aus Silizium-Germanium-Mischmaterial vordringt. Am Rand des dicken Emittergebietes wird eine relativ großflächiger pn-Übergang ausgebildet, wobei der pn-Übergang vollständig im Silizium liegt. Der Basis-Emitter-Diode des Heterobipolartransistors ist eine relativ großflächige Silizium-Diode parallel geschaltet. Diese beeinflusst die elektrischen Eigenschaften des entstehenden Bauelementes und begrenzt dessen geometrische Skalierbarkeit.

Aus der DE 198 45 790 A1 ist ein Herstellungsverfahren für SiGe-Heterobipolartransistoren unter Vermeidung großflächiger Silizium-Randtransistoren bekannt, indem zur nasschemischen Abdünnung von Siliziumschichten im aktiven Emittergebiet eines Bipolartransistors, eine zusätzlich mittels "Atomic Layer Doping" (ALD) in eine Deckelschicht eingebrachte Dotierung mit einer Dicke kleiner 3 nm als Ätzstoppschicht für nasschemische Ätzmittel wirkt. Nachfolgend wird die Ätzstoppschicht mit einem nasschemischen Ätzmittel entfernt wird.

Das Schichtwachstum der Deckelschicht erfolgt über der Ätzstoppschicht weiter einkristallin, so dass mit Hilfe eines Silizium-Ätzmittels, das einkristalline Silizium der Deckelschicht hochselektiv zur Ätzstoppschicht und zu einem Dielektrikum entfernt werden kann. In einer Ausführungsform des Verfahrens der DE 198 45 790 A1 wird die epitaktische Abscheidung der dicken Emitterschicht unterbrochen durch Aufbringen der dünnen Ätzstopschicht, beispielsweise aus hoch-p-dotiertem Silizium, die als Ätzstop bei einer selektiven, nasschemischen Dünnung der dicken Emitterschicht zur Eintiefung des Emitterfensters, am Ort des Emitterfensters dient.

Aus der Druckschrift "IEEE IEDM 2003, Technical Digest, Artikel 5.3.1" ist ebenfalls ein Herstellungsverfahren unter Vermeidung relativ großflächiger Randtransistoren bekannt, indem auf der äußeren Basis eine hohe Siliziddicke erzielt wird, während gleichzeitig die Silizidierungsfront oberhalb der Germanium enthaltenden Schicht zum Stehen gebracht wird. Hierzu wird das Siliziummaterial nach Fertigstellung des Emitteranschlusses ausschließlich oberhalb der äußeren Basis durch selektive Epitaxie abgeschieden und anschließend silizidiert.

Ein weiterer Nachteil des Standes der Technik ergibt sich aus der Tatsache, dass eine sich bei der Silizidierung herausbildende Grenzfläche zwischen Silizid und Silizium im Allgemeinen uneben ausgeprägt ist. Insbesondere besteht die Gefahr der Bildung nadelförmiger oder pyramidaler Silizid-Kristallite, welche in das Siliziumgebiet hineinragen. Zur Vermeidung eines Kurzschlusses ("spike") zwischen der Silizidschicht auf der äußeren Basis und dem Emittergebiet muss hiernach ein ausreichender lateraler Abstand zwischen der Silizidkante und der Emitterkante vorgesehen werden. Hierdurch wird der Bahnwiderstand der äußeren Basis nachteilig erhöht.

Insbesondere bei den in den Schriften US 6,518,111 und US 6,239,477 gelehrten Verfahren wird versucht, den Basis-Bahnwiderstandsanteil aufgrund des nicht silizidierten Bereiches der äußeren Basis zu reduzieren. Hierbei wird zwischen dem Emitterfenster und der äußeren Basis ein großer Mindestabstand gewahrt, um Basis-Emitterkurzschlüsse durch seitlich wachsende Silizidkristalle, so genannte Spikes zu verhindern. Zur Reduktion des Widerstandes wird der Bereich der äußeren Basis, der zwischen dem Silizid und der inneren Basis gelegen ist, durch Dotanden aus einer Feststoff-Dotierstoffquelle möglichst hoch dotiert, ohne die Eigenschaften des Basis-Emitter-PN-Übergangs zu beeinträchtigen.

Als Dotierstoffquelle sieht die US 6,518,111 eine dielektrische Schicht (Bor-Silikat-Glas) als Diffusionsquelle zur Verringerung des Schichtwiderstandes des Verbindungsbereichs zwischen der inneren Basis und einer äußeren Basis aus Polysilizium vor, während die US 6,239,477 eine Dotierung zwischen den inneren Basis und einer silizidierten äußeren Basis vorsieht. In der US 2004/0014271 ist als Feststoffquelle eine selektiv epitaktisch abgeschiedene hochdotierte Siliziumschicht vorgesehen.

Der Erfindung liegt die Aufgabe zu Grunde den Basiswiderstand möglichst zu reduzieren, wobei die Nachteile großer lateraler Ausdehnung und Einflüsse parasitäre Randtransistoren, die zwischen Anschlussgebieten entstehen können, möglichst reduziert werden.

Diese Aufgabe wird durch ein Verfahren mit den Merkmalen eines der Ansprüche 1 oder 13 und durch eine Hochfrequenzanordnung mit den Merkmalen eines der Ansprüche 25 oder 26 gelöst. Weiterbildungen der Erfindung sind Gegenstand von Unteransprüchen.

Demgemäß ist ein Verfahren zur Herstellung eines Halbleitergegenstandes vorgehen, indem ein Basisbereich aus einem ersten Halbleitermaterial und oberhalb des Basisbereichs eine Silizidschicht aufgebracht wird. Die Silizidschicht dient dabei vorzugsweise einem elektrischen Anschluss des Basisbereichs. Für eine gute elektrische Leitfähigkeit wird die Silizidschicht entweder an den Basisbereich angrenzend oder auf eine dünne Zwischenschicht (cap-layer) aus einem Halbleitermaterial aufgebracht.

Das Wesen der Erfindung besteht darin, dass nach dem Aufbringen der Silizidschicht in der Silizidschicht eine Öffnung erzeugt wird, indem die Silizidschicht im Bereich der Öffnung entfernt wird. Demzufolge wird in dieser Öffnung jegliches Silizid entfernt, so dass zumindest eine Oberfläche des unterhalb der Silizidschicht befindlichen monokristallinen Halbleitermaterials freigelegt wird.

Nachfolgend wird innerhalb der Öffnung ein Emitterbereich ausgebildet. Der Emitterbereich ist dabei vorzugsweise derart ausgebildet, dass der Emitterbereich und der Basisbereich einen PN-Übergang bilden der innerhalb eines monokristallinen Bereichs des Halbleitermaterials ausgebildet ist.

Vorteilhafterweise kann mittels dieses Verfahren ein Hochfrequenz-Bipolartransistor (HBT) hergestellt werden. Weiterhin ist die Herstellung anderer Bauelemente, wie Thyristoren, Dioden oder Doppeldioden und ganzer digitaler Logikschaltkreise denkbar.

Eine besonders vorteilhafte Weiterbildung der Erfindung sieht vor, dass zwischen dem Basisbereich und der Silizidschicht eine erste Halbleiterschicht eingefügt wird, indem die erste Halbleiterschicht vor dem Aufbringen der Silizidschicht auf eine erste Oberfläche des Basisbereichs aufgebracht wird. Diese Halbleiterschicht weist vorzugsweise eine gegenüber dem Basisbereich um zumindest eine Größenordnung geringere Dotierstoffkonzentration auf. Beispielsweise ist der Leitungstyp der Dotierstoffe in dieser ersten Halbleiterschicht vom selben Typ des Basisbereichs. Vorteilhafterweise weist die erste Halbleiterschicht eine Dicke kleiner 20 nm auf.

In einer anderen, auch kombinierbaren Weiterbildung der Erfindung ist vorgesehen zwischen der Silizidschicht und der ersten Halbleiterschicht eine zweite Halbleiterschicht einzubringen. Vorzugsweise wird diese zweite Halbleiterschicht in Folge der Erzeugung der Öffnung für den Emitterbereich mit entfernt. Die zweite Halbleiterschicht wird dabei eingebracht, indem die zweite Halbleiterschicht vor dem Aufbringen der Silizidschicht auf eine (zweite) Oberfläche der ersten Halbleiterschicht aufgebracht wird. Dabei weist die zweite Halbleiterschicht gegenüber der ersten Halbleiterschicht vorzugsweise eine höhere Dotierstoffkonzentration auf. Vorteilhafterweise ist die Dotierstoffkonzentration um mindestens eine Größenordnung höher. Die in der zweiten Halbleiterschicht eingebrachten Dotanden sind dabei vom selben Leitungstyp wie die im Basisbereich enthaltenen Dotanden. Die Dotierstoffe können vorteilhafterweise in situ während des epitaktischen Aufbringens der zweiten Halbleiterschicht eingebracht oder alternativ nachträglich implantiert werden. Vorteilhafterweise weist die zweite Halbleiterschicht eine Dicke kleiner 20 nm auf.

Eine vorteilhafter Ausgestaltung der Erfindung sieht vor, dass die Öffnung mit einer Tiefe zumindest bis zur zweiten Oberfläche der ersten Halbleiterschicht oder bis zur ersten Oberfläche der Basisschicht erzeugt wird. Vorteilhafterweise wird die Öffnung bis zu einer Tiefe ausgebildet, dass oberhalb des Basisbereichs monokristallines Halbleitermaterial verbleibt, das als Teil des Emitterhalbleitergebietes mit dem Einbringen des Emitterbereichs entsprechend dotiert wird und vorteilhafterweise nach der Dotierung einen Leitungstyp aufweist, der dem Leitungstyp des Basisbereichs entgegengesetzt ist.

In einer ersten Ausgestaltungsvariante der Erfindung ist vorgesehen, dass die Silizidschicht durch eine Maskierung im Bereich der Öffnung zu deren Erzeugung geätzt wird. Vorzugsweise wird für die Ätzung ein Ätzmittel verwendet, dass eine gegenüber dem unten liegenden, monokristallinen Halbleitermaterial selektive Ätzung der Silizidschicht ermöglicht.

Eine zweite, alternative Ausgestaltungsvariante sieht vor, dass die Öffnung durch einen Abhebetechnik-Verfahrensschritt (lift-off) erzeugt wird. Hierzu wird vor dem Aufbringen der Silizidschicht eine Photolackmaske strukturiert und nachfolgend die Silizidschicht durch Sputtern eines Silizidtarget aufgebracht. Nachfolgend wird die strukturierte Photolackmaske entfernt, so dass die Öffnung in der Silizidschicht gebildet wird.

Eine vorteilhafte Weiterbildung der Erfindung sieht vor, dass der Emitterbereich innerhalb der Öffnung selbstjustierend ausgebildet wird. Hierzu definieren die Ränder der Öffnung der Silizidschicht die Außenmaße des Emitterbereich, so dass der Emitterbereich innerhalb der Öffnung symmetrisch ausgebildet wird. Hierzu ist vorteilhafterweise vorgesehen, dass zur Ausbildung des Emitterbereichs innerhalb der Öffnung Innenspacer erzeugt werden, zwischen denen eine Spaceröffnung ausgebildet wird und anschließend eine leitfähige Schicht oder Schichtfolge aufgebracht wird. Die Innenspacer dienen zur Positionierung des aktiven Emitterhalbleitergebietes unterhalb der Spaceröffnung. Weiterhin dienen die Innenspacer und gegebenenfalls ein weiteres Dielektrikum der Isolation des Emitteranschlusses von der Silizidschicht und/oder des Basisbereichs. Demzufolge wird durch die Innenspacer das Gebiet der inneren Basis festgelegt. Die äußere Basis reicht dabei von der inneren Basis bis unter die Silizidschicht, wobei das Halbleitergebiet des Basisbereichs der äußeren Basis zumindest zum größten Teil durch die Silizidschicht zur Anschlusskontaktierung bedeckt ist.

Um den Emitterbereich möglichst niederohmig zu kontaktieren, ist in einer vorteilhaften Weiterbildung der Erfindung vorgesehen, dass in die leitfähige Schicht oder Schichtfolge ein einem ersten Leitungstyp des Emitterbereichs entsprechender Dotierstoff eingebracht wird, der in einem Temperschritt in die monokristalline Halbleiterschicht im Bereich der Spaceröffnung eindiffundiert wird, so dass die leitfähige Schicht oder Schichtfolge als Quelle des Dotierstoffs wirkt. Die Eindiffusion ist dabei durch entsprechende Temperatur/Zeit-Wahl vorzugsweise auf einen Bereich unterhalb der Spaceröffnung zwischen den Innenspacern beschränkt.

Um die Basis möglichst niederohmig zu kontaktieren und um Schottky-Kontakte zu vermeinden ist gemäß einer Weiterbildung der Erfindung vorgesehen, dass in die Silizidschicht und/oder in die zweite Halbleiterschicht ein einem zweiten Leitungstyp des Basisbereichs entsprechender Dotierstoff eingebracht wird. Dieser wird in einem Temperschritt in die erste Halbleiterschicht und/oder in den Basisbereich außerhalb des Bereichs der Öffnung für den Emitterbereich eindiffundiert, so dass die Silizidschicht und/oder die zweite Halbleiterschicht als Quelle des Dotierstoffs wirkt.

Eine Ausgestaltung dieser Weiterbildung der Erfindung sieht vorteilhafterweise vor, dass die leitfähige Schichtfolge aus einer untenliegenden, insbesondere polykristallinen Siliziumschicht des ersten Leitungstyps und einer obenliegenden weiteren Silizidschicht gebildet wird.

Dabei ist die polykristalline Siliziumschicht vorzugsweise derart hoch dotiert, dass diese eine Dotierstoffkonzentration größer XXX cm⁻³ aufweist.

Die Silizidschicht oder die weitere Silizidschicht wird in einer ersten vorteilhaften Ausgestaltungsvariante der Erfindung aufgebracht, indem zu einer Formierung eine Siliziumschicht und eine oder mehrere Metallschichten, insbesondere ein Titanschicht und/oder eine Kobaltschicht aufgebracht werden und nachfolgend eine Silizidierung erfolgt. Vor und/oder nach der Silizidierung können Dotierstoffe vorzugsweise durch eine entsprechende Maskierung selektiv implantiert werden.

Die Silizidschicht oder die weitere Silizidschicht wird in einer zweiten vorteilhaften Ausgestaltungsvariante der Erfindung aufgebracht, indem ein silizidhaltiges Target gesputtert wird. Dotierstoffe können während des Sputterprozesses in situ eingebracht werden.

Eine vorteilhafte Weiterbildung der Erfindung sieht vor, dass der Basisbereich zumindest eine Silizium-Germanium-Schicht aufweist, indem während des epitaktischen Aufbringens des Basisbereichs ein Gemisch aus Silizium und Germanium aufgebracht wird. Vorteilhafterweise wird diese Silizium-Germanium-Schicht durch eine Schutzschicht, beispielsweise durch die erste Halbleiterschicht abgedeckt, um eine Reaktion des Germaniums mit einem während der Bildung der Silizidschicht aufgebrachten Metalls zu verhindern.

Ein weiterer Aspekt der Erfindung ist eine Hochfrequenzanordnung, insbesondere ein Bipolartransistor, der nach einem zuvor erläuterten Verfahren hergestellt sein kann. Diese Hochfrequenzanordnung weist einen Basisbereich aus einem Halbleitermaterial und eine oberhalb des Basisbereichs angeordnete Silizidschicht auf, die zum elektrischen Anschluss mit des Basisbereichs ausgebildet ist. In die Silizidschicht ist eine Öffnung geätzt, innerhalb derer ein Emitterbereich eingebracht ist, der durch eine Isolatorschicht, beispielsweise einem Dielektrikum von der Silizidschicht elektrisch isoliert ist.

Ein weiterer Aspekt der Erfindung ist ein Verfahren zur Herstellung eines Halbleitergegenstandes, hier insbesondere einer Tetrode. Dabei wird ein erster Basisbereich und ein zweiter Basisbereich ausgebildet. Die beiden Basisbereiche werden bevorzugt von einander getrennt angeschlossen und sind vorteilhafterweise getrennt durch unterschiedliche Basisströme steuerbar.

Zwischen dem ersten Basisbereich und dem zweiten Basisbereich wird ein Zwischenbasisbereich ausgebildet, der vorzugsweise monokristallines Halbleitermaterial aufweist, dass an beide Basisbereiche grenzt. An den ersten Basisbereich angrenzend wird ein Kollektorbereich ausgebildet. Demnach wird der zweite Basisbereich aus einem ersten Halbleitermaterial, beispielsweise Si oder SiGe aufgebracht.

Oberhalb des ersten Basisbereichs wird eine Silizidschicht aufgebracht. Nach dem Aufbringen der Silizidschicht wird in der Silizidschicht eine Öffnung erzeugt, indem die Silizidschicht im Bereich der Öffnung entfernt wird. Nachfolgend wird innerhalb der Öffnung ein an den zweiten Basisbereich angrenzender Emitterbereich ausgebildet.

Eine bevorzugte Weiterbildung der Erfindung sieht vor, dass eine Anschlussschicht aufgebracht wird, die an den ersten Basisbereich grenzt. Die Anschlussschicht ist dabei aus einem Silizidmaterial gebildet, das mit Fremdstoffen, vorzugsweise einem Material der Gruppe 3A des Periodensystems (Bor, etc.), versetzt ist, das in einem angrenzenden Halbleitermaterial als Dotierstoff wirkt, so dass die Anschlussschicht als Dotierstoff-Diffusionsquelle für angrenzende Halbleiterbereiche dient.

In einer anderen, auch kombinierbaren Weiterbildung der Erfindung wird die Anschlussschicht durch Aufbringen eines ersten Dielektrikums von dem Kollektorbereich und/oder durch Aufbringen eines zweiten Dielektrikums vom Zwischenbasisbereich isoliert. Ein derartiges Dielektrikum ist beispielsweise SiO₂ oder Si₃N₄.

Die Erfindung vorteilhaft weiterbildend ist vorgesehen, dass zumindest in der Anschlussschicht ein Basisfenster geöffnet wird, in das eine oder mehrere monokristalline Halbleiterschichten des ersten Basisbereichs selektiv epitaktisch abgeschieden werden. Vorteilhafterweise wird eine der monokristallinen Halbleiterschichten aus einem Mischkristall, beispielsweise SiGe gebildet.

Eine andere bevorzugte Weiterbildung der Erfindung sieht vor, dass zur Ausbildung des Zwischenbasisbereichs auf dem zweiten Dielektrikum und auf der offenliegenden Halbleiterschicht des ersten Basisbereichs zumindest ein Teil des Halbleitermaterials der Zwischenbasisschicht amorph abgeschieden und durch Festphasenepitaxie ausgehend von der offenliegenden Halbleiterschicht des ersten Basisbereichs als Kristallisationskeim kristallisiert wird.

Um die Erfindung weiter vorteilhaft auszugestalten ist vorgesehen, dass die Anschlussschicht aus abgeschiedenem oder durch Silizidierung hergestellten bordotiertem Kobaldsilizid gebildet wird. Hierzu wird in einer ersten Ausgestaltungsvariante der Erfindung die Anschlussschicht aus abgeschiedenem in-situ bordotiertem Kobaltsilizid gebildet, während in einer zweiten Ausgestaltungsvariante die Anschlussschicht aus vermittels Implantation bordotiertem Kobaltsilizid gebildet wird. Vorteilhafterweise wird nach dem Abscheiden der Anschlussschicht ein Temperschritt durchgeführt. Ein weiterer Aspekt der Erfindung ist eine weitere Hochfrequenzanordnung, hier vorzugsweise eine Tetrode. Diese kann mittels des zuvor erläuterten Verfahrens hergestellt werden.

Die Hochfrequenzanordnung weist einen aus einem Halbleitermaterial bestehenden ersten Basisbereich und einem zweiten Basisbereich auf. Zwischen dem ersten Basisbereich und dem zweiten Basisbereich ist ein Zwischenbasisbereich aus einem Halbleitermaterial angeordnet. Zudem sind ein an den ersten Basisbereich angrenzenden Kollektorbereich und ein an den zweiten Basisbereich angrenzenden Emitterbereich vorgesehen.

Weiterhin weist die Hochfrequenzanordnung einen Anschlussbereich auf, der zum elektrischen Anschluss an den ersten Basisbereich angrenzt. Dabei ist der erste Basisbereich in einer Anschlussbereichsöffnung durch selektive Epitaxie als monokristallines Halbleitermaterial ausgebildet. Der Emitterbereich ist in eine Öffnung eingebracht ist, die in eine zum elektrischen Anschluss des zweiten Basisbereichs ausgebildete Silizidschicht geätzt ist.

Im Folgenden wird die Erfindung in Ausführungsbeispielen anhand von zeichnerischen Darstellungen näher erläutert. Dabei zeigen
- Fig. 1a bis 1i: eine schematische Darstellung eines Herstellungsprozesses eines HBTs nach dem Stand der Technik,
- Fig. 2: eine schematische Schnittdarstellung eines Fertigungszustands eines HBTs,
- Fig. 3: eine schematische Schnittdarstellung eines Ausschnitts eines HBTs, und
- Fig. 4: eine schematische Schnittdarstellung einer Tetrode.

In einem ersten Ausführungsbeispiel zur Herstellung eines Hochfrequenzbipolartransistors (HBTs) werden die folgenden Fertigungsverfahrensschritte nacheinander durchgeführt. Zur Vereinfachung sind Detailverfahrensschritte, wie die Reinigung von Oberflächen etc. fortgelassen:
- Einbringen einer vergrabenen n⁺-Schicht 90 in einen Siliziumwafer und
- epitaktisches Aufwachsen von 450 nm Silizium 9, 2e16 cm⁻³ Asdotiert,
- Ätzen einer flachen STI-Grabenisolation mit Nitrid-Hartmaske und
- Verfüllen mit thermischem und/oder aufgebrachtem Oxid,
- Rückätzen des Oxids mit STI-Inversmaske und
- Oxid-CMP mit Nitrid-Hartmaske als Polierstop,
- Basisepitaxie, mit den Schritten
   o 5 nm n⁻-Si-Startschicht,
   o 10 nm intrinsische SiGe-Schicht,
   o 5 nm p⁺-SiGe-Schicht,
   o 5 nm intrinsische SiGe-Schicht,
   o 10 nm bordotierte p⁻-Si-Schicht 4,
   o 10 nm bordotierte p⁺-Si-Capschicht 40 als Diffusionsquelle,
- Sputterabscheidung von 100 nm CoSi₂ und
- Abscheiden von 200 nm Plasma-Si₃N₄,
- Entfernen der Si₃N₄-Schicht 8 an den Stellen, an denen ein Emitterfenster vorgesehen ist,
- Abscheiden von 200 nm Plasma- Si₃N₄ und
- Si₃N₄-Rückätzen auf Zeit, nomineller Abtrag 250 nm (Spacerätzen),
- CoSi₂ trocken auf Zeit ätzen, beispielsweise Cl₂:O₂-Plasma mit einer Selektivität von 30:1 zum unterliegenden Silizium mit etwa 2 bis 3 nm Si-Abtrag,
- Si-Softetch mit 5 nm Si-Abtrag.

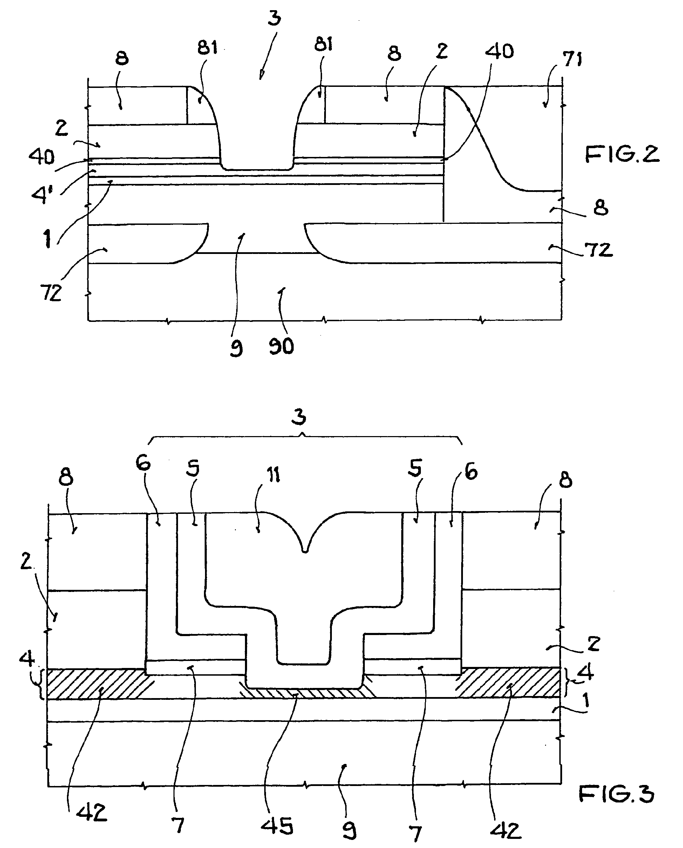

Den Fertigungsverfahrenszustand nach diesen Verfahrensschritten zeigt schematisch Fig. 2. Dabei gelten die folgenden Leitungstypen für einen Hochfrequenz-npn-Biplartransistor. Der Kollektorbereich ist durch eine n⁺⁻dotierte, vergrabene Schicht 90 und durch eine n⁻-Schicht 9 gebildet, wobei diese Schichten 90 und 9 zwischen zwei dielektrischen Schichten 72 aneinander grenzen und in diesem Bereich das Kristallgitter des Substrats fortsetzten. Auf der n⁻-Schicht 9 ist der Basisbereich 1 angeordnet, der in diesem Ausführungsbeispiel zur vereinfachten Darstellung lediglich aus einer Schicht besteht. Auf dem Basisbereich 1 sind eine erste Halbleiterschicht 4 und eine zweite Halbleiterschicht 40 angeordnet, die im Gegensatz zum Basisbereich 1 kein Germanium aufweisen. Weiterhin ist zur Separierung dieser Hochfrequenzhalbleiteranordnung von anderen Hochfrequenzhalbleiteranordnungen ein Dielektrikum aus einer Si₃N₄-Schicht 8 und einer SiO₂-Schicht 71 vorgesehen.

Oberhalb der zweiten Halbleiterschicht 40 und somit auch oberhalb des Basisbereichs 1 ist eine Silizidschicht 2 angeordnet, in die mittels der Hartmaske aus der Si₃N₄-Schicht 8 und den Spacern 81 eine Öffnung 3 geätzt ist, wobei innerhalb dieser Öffnung in nachfolgenden Schritten der Emitterbereich ausgebildet wird.

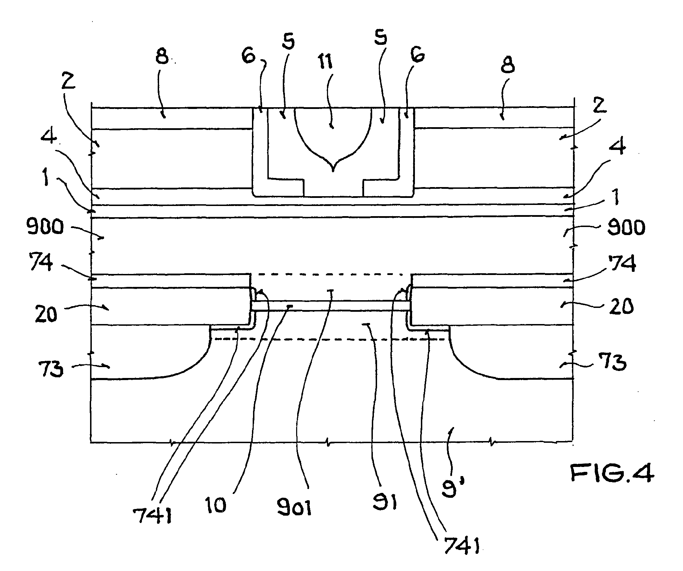

In der Fig. 3 ist in einem weiteren Ausführungsbeispiel der Erfindung eine Schnittansicht durch den Basis-Emitterbereich eines npn-Hochfrequenzbipolartransistors schematisch dargestellt. Analog zu Fig. 2 bildet die Schicht 9 einen Teil eines niedrig n-dotierten Kollektorbereiches, auf dem der p-dotierte Basisbereich 1 angeordnet ist. Oberhalb des Basisbereichs 1 ist lediglich eine Halbleiterschicht 4 angeordnet, oberhalb derer wiederum eine Silizidschicht 2 und eine Hartmaske aus Si₃N₄ (8) angeordnet ist. Durch die Silizidschicht 2 hindurch reicht eine Öffnung 3 innerhalb derer der Emitterbereich (5, 11) angeordnet ist.

Innerhalb der Öffnung 3 sind zwei Innenspacer 6 jeweils oberhalb von einem thermischen Oxid 7 angeordnet. An die Innenspacer 6 angrenzend ist polykristallines, n⁺-(hoch)dotiertes Silizium aufgebracht, das ebenfalls eine Spaceröffnung zwischen den beiden Innenspacern 6 verfüllt. Der verbleibende Teil der Öffnung 3 des Emitterbereichs ist mit einem Silizid 11 und ggf. weiteren (in Fig. 3 nicht dargestellten) metallischen Leitern verfüllt.

Das Polysilizium 5 dient zudem als Dotierstoffquelle zur Dotierung der monokristallinen Halbleiterschicht 4 im Emitterbereich 45, der hierzu durch Dotanden aus dem Polysilizium 5 hoch n⁺-dotiert ist und das aktive Emittergebiet 45 bildet. Weiterhin wirkt die Silizidschicht 2 als Dotierstoffquelle, wobei die erste Halbleiterschicht 4 im Bereich der äußeren Basis 42 hoch p⁺-dotiert ist. Dies ermöglicht einen besonders niederohmigen Anschluss der äußeren Basis 42, 1.

Fig. 4 zeigt in Form einer schematischen Schnittdarstellung eine vertikal integrierte Kaskodenstruktur. Die Bezeichnungen 2, 4, 5, 6, 8 und 11 entsprechen dem Ausführungsbeispiel der Fig. 2. Die Fig. 2 zeigt jedoch einen Ausschnitt eines Hochfrequenzbipolartransistors, während Fig. 3 eine schematische Darstellung einer Hochfrequenzkaskodenstruktur zeigt. Demzufolge ist in der Fig. 3 ein erster Basisbereich 10 und ein zweiter Basisbereich 1 vorgesehen. Oberhalb des zweiten Basisbereichs 1 entspricht der Aufbau der vertikal integrierten Kaskodenstruktur dem Bipolartransistor aus Fig. 2.

Zwischen dem ersten Basisbereich und dem zweiten Basisbereich ist ein Zwischenbasisbereich 900 angeordnet. Dieser Zwischenbasisbereich 900 weist einen dem Leitungstyp der beiden Basisbereiche 1, 10 entgegengesetzten Leitungstyp auf. In diesem Ausführungsbeispiel sind die Basisbereiche 1, 10 p-dotiert, während der Zwischenbasisbereich 900 n-dotiert ist.

Zum Anschluss des ersten Basisbereichs 10 ist eine Silizidschicht 20 vorgesehen, die durch ein Dielektrikum 73, 74, beispielsweise SiO₂, von dem Kollektorbereich 9 und dem Zwischenbasisbereich 900 isoliert ist. Zwischen den Silizidbereichen 20 ist monokristallines Halbleitermaterial durch selektive Epitaxie aufgebracht, das einen Schichtstapel aus den Schichten 91, 10 und 901 bildet. Sowohl der erste Basisbereich als auch der zweite Basisbereich weisen einen SiGe-Mischkristall auf.

Die Silizidschicht 20 ist im Ausführungsbeispiel mit Bor versetzt und dient unter Temperaturbeaufschlagung als Feststoffquelle für die Dotierung der angrenzenden Siliziumbereiche 91, 901. Hierbei bilden sich p-dotierte Randbereiche 741 um die Silizidschicht 20. Es werden auf diese Weise Kurzschlüsse zwischen der Silizidschicht 20 und dem n-dotierten Schichten 9, 91 und 901 vermieden.

Zur Herstellung der vertikal integrierten Kaskodenstruktur aus Fig. 4 werden vorzugsweise folgende Fertigungsverfahrensschritte durchgeführt:
- Erzeugen einer einen Kollektorbereich aus der Kollektorschicht 9 bedeckenden Hartmaske auf einer ersten Siliziumoberfläche,
- Selektives Entfernen der nicht von der Hartmaske bedeckten Teile der Kollektorschicht 9,
- Thermisches Oxidieren der nach dem selektivem Entfernen der Kollektorschicht freiliegenden Siliziumoberfläche,
- Abscheiden einer ersten dielektrischen Schicht 73,
- Abtragen des oberhalb der der ersten Siliziumoberfläche abgewandten Oberfläche der Hartmaske liegenden Materials der ersten dielektrischen Schicht 73,
- Entfernen der Hartmaske,
- Aufbringen einer Schichtfolge aus einer Anschlussschicht 20, wobei die Anschlussschicht aus Silizidmaterial ausgeführt ist und mit einem Material der Gruppe 3A des Periodensystems versetzt ist, so dass diese Anschlussschicht 20 als Feststoff-Diffusionsquelle für angrenzende Halbleiterbereiche 10 dient,
- Aufbringen einer zweiten dielektrischen Schicht 74,
- Öffnen eines Basisfensters oberhalb des Kollektorbereichs in der zweiten dielektrischen Schicht 74 und der Anschlussschicht 20,
- Selektives epitaktisches Abscheiden einer ersten monokristallinen Halbleiterschicht 10 oder eines ersten monokristallinen Halbleiterschichtstapels in der Öffnung des Basisfensters, wobei die erste monokristalline Halbleiterschicht 10 eine erste p-dotierten SiGe-Schicht bzw. der Stapel eine SiGe-Schicht aufweist,
- Nicht-selektives Abscheiden einer amorphen, n-dotierten Siliziumschicht,
- Kristallisation der amorphen, n-dotierten Siliziumschicht durch Festphasenepitaxie zu zumindest einem Teil der Zwischenbasisschicht 900, ausgehend von der ersten monokristallinen Halbleiterschicht 10 oder dem Halbleiterschichtstapel, so dass zumindest Bereiche der Zwischenbasisschicht 900 monokristallin ausgebildet werden.

Für den Bereich oberhalb der Zwischenbasisschicht 900 gelten die Verfahrensschritte zum Bipolartransistor analog.

## Patentansprüche

1. Verfahren zur Herstellung eines Halbleitergegenstandes, insbesondere eines Bipolartransistors,
wobei
- ein Basisbereich (1) aus einem ersten Halbleitermaterial aufgebracht wird,
- oberhalb des Basisbereichs (1) eine Silizidschicht (2) aufgebracht wird,
- nach dem Aufbringen der Silizidschicht (2) in der Silizidschicht (2) eine Öffnung (3) erzeugt wird, indem die Silizidschicht (2) im Bereich der Öffnung (3) entfernt wird, und
- nachfolgend innerhalb der Öffnung (3) ein Emitterbereich ausgebildet wird.

2. Verfahren nach Anspruch 1, **dadurch gekennzeichnet, dass** zwischen dem Basisbereich (1) und der Silizidschicht (2) eine erste Halbleiterschicht (4) eingefügt wird, indem die erste Halbleiterschicht (4) vor dem Aufbringen der Silizidschicht (2) auf eine erste Oberfläche des Basisbereichs (1) aufgebracht wird.

3. Verfahren nach Anspruch 2, **dadurch gekennzeichnet, dass** zwischen die Silizidschicht (2) und die erste Halbleiterschicht (4) eine zweite Halbleiterschicht (40) eingebracht wird, indem die zweite Halbleiterschicht (40) vor dem Aufbringen der Silizidschicht (2) auf eine zweite Oberfläche der ersten Halbleiterschicht (4) aufgebracht wird, wobei vorzugsweise die zweite Halbleiterschicht (40) gegenüber der ersten Halbleiterschicht (4) eine höhere Dotierstoffkonzentration aufweist.

4. Verfahren nach einem der Ansprüche 2 oder 3, **dadurch gekennzeichnet, dass** die Öffnung (3) mit einer Tiefe zumindest bis zur zweiten Oberfläche der ersten Halbleiterschicht (4) oder bis zur ersten Oberfläche der Basisschicht (1) erzeugt wird.

5. Verfahren nach einem der vorhergehenden Ansprüche, **dadurch gekennzeichnet, dass** der Emitterbereich innerhalb der Öffnung (3) selbstjustierend ausgebildet wird.

6. Verfahren nach einem der vorhergehenden Ansprüche, **dadurch gekennzeichnet, dass** zur Ausbildung des Emitterbereichs innerhalb der Öffnung (3) Innenspacer (6) erzeugt werden und anschließend eine leitfähige Schicht (5) oder Schichtfolge (5,11) aufgebracht wird.

7. Verfahren nach Anspruch 6, **dadurch gekennzeichnet, dass** in die leitfähige Schicht (5) oder Schichtfolge (5,11) ein Fremdstoff eingebracht wird, welcher während eines Temperschritts in die Halbleiterschicht (4) im Bereich der Öffnung (3) eindiffundiert wird und innerhalb der Halbleiterschicht (4) als Dotierstoff eines ersten Leitungstyps wirkt, so dass die leitfähige Schicht (5) oder Schichtfolge (5,11) als Quelle des Dotierstoffs dient.

8. Verfahren nach einem der vorhergehenden Ansprüche, **dadurch gekennzeichnet, dass** in die Silizidschicht (2) und/oder in die zweite Halbleiterschicht (40) ein Fremdstoff eingebracht wird, welcher während eines Temperschritts in die erste Halbleiterschicht (4) und/oder in den Basisbereich (1) außerhalb des Bereichs der Öffnung (3) eindiffundiert wird und innerhalb der ersten Halbleiterschicht (4) als Dotierstoff eines zweiten Leitungstyps wirkt, so dass die Silizidschicht (2) und/oder die zweite Halbleiterschicht (40) als Quelle des Dotierstoffs wirkt.

9. Verfahren zumindest nach Anspruch 6, **dadurch gekennzeichnet, dass** die leitfähige Schichtfolge aus einer untenliegenden, insbesondere polykristallinen oder amorphen Siliziumschicht (5) des ersten Leitungstyps und einer obenliegenden weiteren Silizidschicht (11) gebildet wird.

10. Verfahren nach einem der vorhergehenden Ansprüche, **dadurch gekennzeichnet, dass** die Silizidschicht (2) oder die weitere Silizidschicht (11) aufgebracht wird, indem zu einer Formierung eine Siliziumschicht und eine oder mehrere Metallschichten, insbesondere ein Titanschicht und/oder eine Kobaltschicht aufgebracht werden.

11. Verfahren nach einem der Ansprüche 1 bis 9, **dadurch gekennzeichnet, dass** die Silizidschicht (2) oder die weitere Silizidschicht (11) aufgebracht wird, indem ein silizidhaltiges Target gesputtert wird.

12. Verfahren nach einem der vorhergehenden Ansprüche, **dadurch gekennzeichnet, dass** der Basisbereich (1) zumindest eine Silizium-Germanium-Schicht aufweist.

13. Verfahren insbesondere nach einem der vorhergehenden Ansprüche, zur Herstellung eines Halbleitergegenstandes, insbesondere einer vertikal integrierten Kaskodenstruktur,
wobei
- ein erster Basisbereich (10) und ein zweiter (1) Basisbereich ausgebildet wird,
- zwischen dem ersten Basisbereich (10) und dem zweiten Basisbereich (1) ein Zwischenbasisbereich (900) ausgebildet wird,
- an den ersten Basisbereich (10) angrenzend ein Kollektorbereich (91,9') ausgebildet wird,
- der zweite Basisbereich (1) aus einem ersten Halbleitermaterial aufgebracht wird,
- oberhalb des zweiten Basisbereichs (1) eine Silizidschicht (2) aufgebracht wird,
- nach dem Aufbringen der Silizidschicht (2) in der Silizidschicht (2) eine Öffnung (3) erzeugt wird, indem die Silizidschicht (2) im Bereich der Öffnung (3) entfernt wird, und
- nachfolgend innerhalb der Öffnung (3) ein an den zweiten Basisbereich (1) angrenzender Emitterbereich ausgebildet wird.

14. Verfahren nach Anspruch 13, **dadurch gekennzeichnet, dass** der erste Basisbereich (10), der zweite Basisbereich (1) und/oder der Zwischenbasisbereich (900) als Schichten ausgebildet wird, wobei diese vorzugsweise zueinander horizontale Grenzflächen ausbilden.

15. Verfahren nach einem der Ansprüche 13 oder 14, **dadurch gekennzeichnet, dass** eine an den ersten Basisbereich (10) angrenzende Anschlussschicht (20) aufgebracht wird,
- die aus einem Silizidmaterial ausgebildet ist, das mit zumindest einem Fremdstoff versetzt ist, welcher in einem an das Silizidmaterial angrenzenden Halbleitermaterial (901,10,91,9') als Dotierstoff wirken kann,und
- die als Diffusionsquelle zur Dotierung eines an die Anschlussschicht (20) angrenzenden Halbleiterbereichs (901,10,91,9') dient.

16. Verfahren nach Anspruch 15, **dadurch gekennzeichnet, dass** die Anschlussschicht (20) durch Aufbringen eines ersten Dielektrikums (73) von dem Kollektorbereich (9') isoliert wird.

17. Verfahren nach einem der Ansprüche 15 oder 16, **dadurch gekennzeichnet, dass** die Anschlussschicht (20) durch Aufbringen eines zweiten Dielektrikums (74) von dem Zwischenbasisbereich (900) isoliert wird.

18. Verfahren nach einem der Ansprüche 15 bis 17, **dadurch gekennzeichnet, dass** zumindest in der Anschlussschicht (20) ein Basisfenster geöffnet wird, in das eine oder mehrere monokristalline Halbleiterschichten des ersten Basisbereichs (10) selektiv epitaktisch abgeschieden werden.

19. Verfahren nach den Ansprüchen 17 oder 18, **dadurch gekennzeichnet, dass** zur Ausbildung des Zwischenbasisbereichs (900) auf dem zweiten Dielektrikum (74) und auf der offenliegenden Halbleiterschicht des ersten Basisbereichs (1) zumindest ein Teil des Halbleitermaterials der Zwischenbasisschicht (900) amorph abgeschieden und durch Festphasenepitaxie, ausgehend von der offenliegenden Halbleiterschicht des ersten Basisbereichs (1) als Kristallisationskeim, kristallisiert wird.

20. Verfahren nach einem der Ansprüche 15 bis 19, **dadurch gekennzeichnet, dass** die Anschlussschicht (20) aus abgeschiedenem oder durch Silizidierung hergestellten mit Bor versetztem Kobaldsilizid gebildet wird.

21. Verfahren nach Anspruch 20, **dadurch gekennzeichnet, dass** die Anschlussschicht (20) aus abgeschiedenem in-situ mit Bor versetztem Kobaltsilizid gebildet wird.

22. Verfahren nach Anspruch 20, **dadurch gekennzeichnet, dass** die Anschlussschicht (20) aus vermittels Implantation bordotiertem Kobaltsilizid gebildet wird.

23. Verfahren nach einem der Ansprüche 14 bis 22, **dadurch gekennzeichnet, dass** nach dem Abscheiden der Anschlussschicht (20) ein Temperschritt durchgeführt wird.

24. Verfahren nach Anspruch 23, **dadurch gekennzeichnet, dass** auf die Aufbringung der Anschlussschicht (20) nachfolgende Epitaxie- oder Abscheideschritte als Temperschritte wirken.

25. Halbleitergegenstand, insbesondere ein Hochfrequenz-Bipolartransistor, vorzugsweise mittels des Verfahrens hergestellt nach einem der Ansprüche 1 bis 12, mit
- einem Basisbereich (1) aus einem Halbleitermaterial,
- einer oberhalb des Basisbereichs (1) angeordneten Silizidschicht (2), die zum elektrischen Anschluss des Basisbereichs (1) ausgebildet ist,
- einer in die Silizidschicht (2) geätzten Öffnung (3), innerhalb derer ein Emitterbereich eingebracht ist, der durch eine Isolatorschicht (6, 7) von der Silizidschicht (2) elektrisch isoliert ist.

26. Halbleitergegenstand, insbesondere eine vertikal integrierte Hochfrequenz-Kaskodenstruktur, vorzugsweise mittels des Verfahrens hergestellt nach einem der Ansprüche 13 bis 23, mit
- einem ersten Basisbereich (10) und einem zweiten Basisbereich (1),
- einem zwischen dem ersten Basisbereich (10) und dem zweiten Basisbereich (1) angeordneten Zwischenbasisbereich (900),
- einem an den ersten Basisbereich (10) angrenzenden Kollektorbereich (91,9'),
- einem an den zweiten Basisbereich (1) angrenzenden Emitterbereich, und
- einem Anschlussbereich (20), der zum elektrischen Anschluss an den ersten Basisbereich (10) angrenzt,
wobei
- der erste Basisbereich (10) in einer Anschlussbezeichsöffnung durch selektive Epitaxie als monokristallines Halbleitermaterial ausgebildet ist, und
- der Emitterbereich in eine Öffnung (3) eingebracht ist, die in eine zum elektrischen Anschluss des zweiten Basisbereichs (1) ausgebildete Silizidschicht (2) eingebracht ist.
